# DEMANDE DE BREVET EUROPEEN

(11) **EP 4 553 196 A1**
(43) Date de publication de la demande: **14.05.2025**
(21) Numéro de dépôt: 23208878.1
(22) Date de dépôt: 09.11.2023
(51) Int. Cl.: C30B 11/00, C30B 11/10, C30B 29/20

(54) **PROCÉDÉ DE FABRICATION DE SAPHIR EN BARRE**

(71) Demandeur: Comadur S.A., 2400 Le Locle (CH)
(72) Inventeur: COCHET-MUCHY, Didier, 38570 Hurtières (FR)
(74) Mandataire: ICB SA

(57) **Abrégé**

L'invention concerne un procédé de fabrication d'un saphir monocristallin directement sous forme de barre, le procédé comprenant les étapes suivantes :
- mise à disposition d'un creuset (100), le creuset comprenant une première partie fixe (1) avec une ouverture interne (13), et une deuxième partie (2) mobile formant le fond du creuset et qui est constituée d'une pièce en saphir formant un germe de départ pour la croissance du saphir ;
- mettre en place la première partie (1) et la deuxième partie (2) l'une par rapport à l'autre, la deuxième partie étant mobile en translation dans l'ouverture interne (13) de la première partie ;
- placer le creuset (100) dans une enceinte (4) sous vide ou sous atmosphère contrôlée et chauffer dans l'enceinte (4) pour mettre à température de fonctionnement le creuset ;
- alimenter le creuset avec de la matière première (M) via un système d'alimentation (3) pour former de la matière première en fusion (F) dans le creuset ;
- effectuer un déplacement en translation du fond (2) du creuset, à vitesse contrôlée, pour solidifier progressivement la matière première en fusion et former progressivement une barre de saphir (C) ;
- interrompre l'alimentation de matière première (M) et cristalliser complètement la matière en fusion (F) restante dans le creuset ;
- refroidir le creuset jusqu'à température ambiante ;
- récupérer la barre de saphir soudée au germe obtenue, le germe et/ou une portion de la barre pouvant être sciée pour former à la fois un nouveau fond et un nouveau germe de départ.

## Description

### Domaine technique de l'invention

La présente invention concerne un procédé de fabrication d'un saphir monocristallin directement sous forme de barre. La présente invention concerne également des composants d'habillage et fonctionnels pour l'horlogerie et la bijouterie découpés dans un tel monocristal de saphir.

### Arrière-plan technologique

Il existe plusieurs types de procédés pour obtenir un monocristal artificiel :
- à partir d'une solution sursaturée du composé ;
- à partir du composé en fusion ;
- par transport chimique en phase vapeur.

On connait par exemple le procédé Verneuil. Pour synthétiser le corindon de formule Al₂O₃ qui compose les rubis et les saphirs, il est nécessaire de monter à très haute température (fusion à 2050°C), température que l'on atteint au moyen d'un chalumeau oxhydrique H₂ + ½ O₂ →H₂O dont la température de flamme est de 2700°C environ. De l'alumine, éventuellement dopée, est introduite sous forme de poudre fine par un vibreur qui en fait tomber de petites quantités directement dans la flamme du chalumeau. La goutte d'alumine en fusion alors formée tombe au sommet du germe et cristallise en suivant l'arrangement cristallographique de ce germe. Le monocristal en croissance est progressivement abaissé pour que la cristallisation s'opère à température constante. En fin de synthèse, un monocristal en forme de bouteille est obtenu.

Néanmoins, les monocristaux de saphir obtenus par le procédé Verneuil présentent de fortes densités de dislocations et des désorientations locales incontrôlables. D'autres défauts également présents dans les monocristaux Verneuil tels que des bulles, des voiles et autres inclusions sont quant à eux susceptibles de se voir à l'œil nu par exemple dans une glace de montre finie.

Par ailleurs le contrôle effectif de la forme des cristaux Verneuil est relativement mauvais, au mieux +/- 2 mm sur le diamètre.

Le procédé Czochralski est une technique de cristallisation à partir d'un bain en fusion dans un creuset. Elle est théoriquement bien adaptée à la production de saphir de forme cylindrique, dont la taille n'est limitée que par celle du creuset. La vitesse de tirage étant précisément contrôlée, le diamètre moyen peut être maintenu très proche de la valeur recherchée grâce à un capteur pesant le cristal, mesure de poids qui est utilisée pour calculer l'écart par rapport à ce diamètre et réguler en conséquence la température de cristallisation.

Toutefois, contrôler le diamètre moyen n'empêche pas que la forme effective du cristal saphir peut dans certains cas s'éloigner significativement du cylindre idéal. Comme le cristal en croissance est libre de tout contact avec le creuset, aucune contrainte de forme ne lui est mécaniquement imposée. Des facettes, surfaces planes de moindre énergie, vont pouvoir apparaitre, en relation avec l'orientation de tirage. Dans certains cas, tels que la croissance selon l'axe A, des facettes perpendiculaires à C apparaissent, pouvant donner une anisotropie de forme très prononcée.

Notons aussi que la technique Czochralski nécessite un bain de saphir d'une hauteur importante puisque toute la matière première destinée à former le cristal doit être contenue dans le creuset, ce qui le rend plus difficile à dégazer. Des bulles et microbulles peuvent potentiellement se retrouver à l'intérieur du cristal, celui-ci poussant au-dessus du bain.

Dans la technique EFG (Edge-defined Film-fed Growth), la cristallisation du saphir s'opère au sommet d'une filière, plongée dans un bain de saphir en fusion. La filière donne son profil au cristal produit. Des plaques, tubes et petits barreaux peuvent être obtenus, afin de s'approcher des dimensions finales. Toutefois, le saphir fondu devant remonter au sommet de la filière par un canal capillaire très fin (maximum 0.8 - 1 mm dans une dimension), le profil comportera lui aussi une dimension d'épaisseur limitée, typiquement 20 mm maximum. De plus, la cristallisation s'effectuant au-dessus du bain, les bulles qui s'y sont formées et les gaz dissous vont pouvoir remonter jusque dans le cristal. En particulier, il va systématiquement apparaitre des microbulles au voisinage des surfaces, typiquement jusqu'à une profondeur de 0.5 mm, ce qui limite la partie utile du saphir produit et nécessite d'usiner toutes les surfaces sur cette profondeur.

Dans la technique Micro-Pulling-Down, la cristallisation du saphir se déroule en dessous du bain de saphir en fusion, ce qui limite les problèmes d'incorporation ou de nucléation de bulles et microbulles précédemment évoqués. Toutefois, l'alimentation de la zone de cristallisation se fait toujours par une voie capillaire, à savoir un fin trou ou une fine fente percée dans le fond du creuset contenant le bain de saphir, sous lequel ou laquelle un germe de saphir doit être approché pour que se forme un ménisque liquide stable entre le creuset et ce germe. Les conditions de stabilité du ménisque se réduisent au fur et à mesure que sa surface augmente, ce qui limite malheureusement grandement les dimensions accessibles par Micro-Pulling-Down.

Les techniques de cristallisation Bridgman horizontales et verticales, et leurs variantes (HDC - Horizontal Directional Crystalllization ou Bagdasarov, HEM - Heat Exchanger Method, VGF - Vertical Gradient Freeze, etc.) : toutes ses techniques se caractérisent par le fait que le cristal pousse directement au contact du creuset, lequel détermine donc précisément la forme du saphir obtenu, permettant de s'approcher au plus près des formes du produit final. Toutefois, cet avantage présente un inconvénient en terme de coût, puisque le creuset doit être en général détruit pour récupérer le cristal et doit être renouvelé à chaque cycle de cristallisation. De plus, toute la matière première destinée à former le cristal doit être contenu dans le creuset et fusionnée entièrement, la hauteur du bain peut donc être importante et par conséquent être un obstacle à un dégazage efficace du point de vue de la qualité optique du cristal.

### Résumé de l'invention

La présente invention a pour but de remédier aux problèmes mentionnés ci-dessus ainsi qu'à d'autres encore en proposant un procédé de fabrication de monocristaux de saphir directement sous forme de barres.

Un tel procédé permet d'optimiser la cristallisation de saphir directement sous forme de barre de section et de longueur facilement adaptables et précisément contrôlables, sans utilisation d'effets capillaires limitant une des trois dimensions, approchant au plus près les dimensions finales recherchées, notamment celle des composants horlogers, et également aisément sciables en tranches par sciage au fil, le tout permettant de réduire considérablement les pertes de matière à l'usinage.

L'invention vise également à permettre la réutilisation des outillages du procédé plusieurs fois afin de réduire les coûts.

L'invention vise aussi à optimiser la qualité optique des cristaux produits en contrôlant l'atmosphère sous laquelle se déroule le procédé et en limitant la quantité de bain fondu pour faciliter son dégazage.

L'invention vise enfin à optimiser la qualité optique des cristaux produits en faisant croitre le cristal en dessous du bain en fusion, afin de limiter l'incorporation au cristal des bulles, microbulles et gaz résiduels dans le bain.

A cet effet, la présente invention concerne un procédé de fabrication d'un saphir monocristallin sous forme de barre, le procédé comprenant les étapes suivantes :
- mise à disposition d'un creuset, le creuset comprenant une première partie fixe avec une ouverture interne, et une deuxième partie mobile formant le fond du creuset et qui est constituée d'une pièce en saphir formant un germe de départ pour la croissance du saphir ;
- mettre en place la première partie et la deuxième partie l'une par rapport à l'autre à la température ambiante, la deuxième partie étant mobile en translation dans l'ouverture interne de la première partie ;

- placer le creuset dans une enceinte sous vide ou sous atmosphère contrôlée et chauffer dans l'enceinte pour mettre à température de fonctionnement le creuset ;
- alimenter le creuset avec de la matière première, préférentiellement via un réservoir et un système d'alimentation pouvant fonctionner en continu ou non, pour former de la matière première en fusion dans le creuset, au-dessus de la partie mobile en saphir ;
- effectuer un déplacement en translation du fond du creuset vers la zone basse moins chauffée via des moyens de déplacement en translation, à vitesse contrôlée, pour solidifier progressivement la matière première en fusion et former progressivement une barre de saphir ayant la même section que celle du fond du creuset ;
- interrompre l'alimentation de matière première et cristalliser complètement la matière en fusion restante dans le creuset ;
- refroidir le creuset jusqu'à température ambiante ;
- récupérer la barre de saphir obtenue, une portion de la barre pouvant, après sciage, former à la fois un nouveau fond et un nouveau germe de départ.

Selon des formes particulières de mise en oeuvre du procédé selon l'invention :
- l'ouverture interne de la première partie est cylindrique et présente une section sensiblement correspondant à la section souhaitée de la barre de saphir ;
- le fond en saphir est de forme cylindrique et présente une section correspondant à la section souhaitée de la barre de saphir ;
- la première partie du creuset est réalisée en un métal réfractaire tel que du molybdène, du tungstène ou un alliage de ces deux métaux ;
- la température de fonctionnement de l'enceinte est comprise entre 2000°C et 2100°C ;
- les première partie et deuxième partie sont dimensionnées pour atteindre un jeu minimal lorsqu'elles sont à température de fonctionnement ;
- la matière première est de composition chimique Al2O3 pure ou dopée ;
- la matière première est choisie parmi du saphir craquelé broyé, des billes de saphir ou d'alumine, ou de la poudre d'alumine densifiée et compactée sous forme de pellets ;
- l'atmosphère contrôlée est composée d'un gaz neutre ;
- le gaz neutre est de l'argon ;
- le déplacement est géré par un système de translation motorisé ;
- la capacité du réservoir d'alimentation de matière première est au moins égale à celle du poids de la barre de saphir pouvant être cristallisée ;
- l'orientation cristallographique du fond ou germe de saphir peut être choisie indistinctement parmi toutes les orientations cristallographiques du saphir ;
- une fois la barre de saphir obtenue, on découpe des composants d'habillage ou fonctionnels pour l'horlogerie et la bijouterie dans cette barre de saphir ;
- la découpe des composants d'habillage ou fonctionnels pour l'horlogerie et la bijouterie dans cette barre de saphir est effectuée par sciage au fil ;
- une même enceinte sous vide ou sous atmosphère contrôlée est utilisée pour plusieurs creusets, systèmes de chauffage, d'alimentation en matière première et moyens de déplacement en translation.

L'invention concerne également des composants d'habillage et fonctionnels pour l'horlogerie et la bijouterie, notamment des ponts, des platines, des glaces, des boîtes et des cadrans de montre ou bien encore des maillons de bracelet, découpés dans un monocristal de saphir obtenu conformément au procédé de l'invention.

Grâce à ces caractéristiques, la présente invention procure un procédé qui permet de fabriquer des glaces de montres dans des conditions d'usinage facilitées et avec des pertes minimales.

### Brève description des figures

D'autres caractéristiques et avantages de la présente invention ressortiront plus clairement de la description détaillée qui suit d'un exemple de mise en oeuvre du procédé selon l'invention, cet exemple étant donné à titre purement illustratif et non limitatif seulement en liaison avec le dessin annexé sur lequel :
- la figure 1 illustre la deuxième étape du procédé selon l'invention ;
- la figure 2 illustre la troisième étape du procédé conformément à l'invention ;
- la figure 3 illustre les coefficients de dilatation comparés du molybdène, du tungstène et du saphir en fonction de la température (selon C. Miyogawa et al., J. Cryst. Growth 372 (2013) pages 95-99);
- la figure 4 illustre la quatrième et la cinquième étape du procédé conformément à l'invention ;
- la figure 5 illustre un schéma de principe d'une enceinte-four pour la croissance de plusieurs barres de saphir en parallèle.

### Description détaillée de l'invention

La présente invention concerne un procédé de fabrication (ou de cristallisation) d'un saphir monocristallin directement sous forme de barre.

La première étape du procédé consiste à mettre en place un creuset 100 agencé pour recevoir une matière première « M » où elle est fondue par un apport de chaleur.

La matière première « M » utilisée pour la fabrication de saphir est de composition chimique Al₂O₃ pure ou dopée. La matière première « M » peut être choisie parmi du saphir craquelé broyé, des billes de saphir ou d'alumine, ou de la poudre d'alumine densifiée et compactée sous forme de pellets.

Selon l'invention, le creuset 100 comprend une première partie fixe 1 avec une ouverture interne 13, et une deuxième partie mobile 2 formant le fond du creuset et qui constituée d'une pièce en saphir formant un germe de départ pour la croissance du saphir.

Le fond 2 du creuset peut présenter une épaisseur comprise entre 1 cm et 10 cm.

Selon un mode de réalisation alternatif, il peut être également envisageable de disposer une pièce métallique intermédiaire formant un fond métallique circulaire sur lequel est fixé le germe de départ

Telle qu'illustrée, l'ouverture interne 13 de la première partie 1 est cylindrique, s'étend sur la hauteur de la première partie, et présente une section correspondant sensiblement à la section de la barre de saphir que l'on souhaite fabriquer. De même, le fond 2 en saphir est de forme cylindrique et présente une section correspondant à la section souhaitée de la barre de saphir. La forme et la dimension du cylindre vont définir précisément la forme et la dimension des barres de saphir que l'on va cristalliser.

Bien évidemment, l'ouverture interne 13 peut présenter une grande variété de formes de section transversale par rapport à l'axe longitudinal du creuset, et la forme de la section transversale dépend de la section transversale du cristal de saphir à produire.

Ainsi, la section transversale interne peut par exemple être circulaire, ovale ou polygonale. La section transversale polygonale peut par exemple prendre la forme d'un carré, d'un rectangle, d'un pentagone, d'un hexagone ou encore d'un octogone.

La première partie 1 du creuset 100 est de préférence réalisée en un métal réfractaire tel que du molybdène, du tungstène ou un alliage de ces deux métaux.

L'étape suivante du procédé consiste à mettre en place la première partie 1 et la deuxième partie 2 l'une par rapport à l'autre à la température ambiante, la deuxième partie 2 étant mobile en translation dans l'ouverture interne 13 de la première partie.

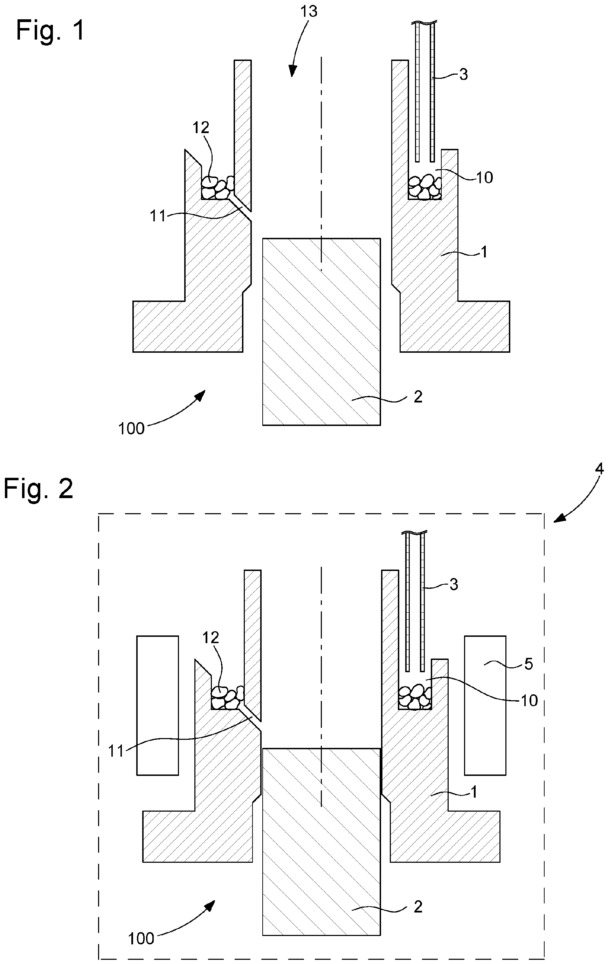

La première partie 1 métallique du creuset et le fond 2 en saphir du creuset (ou germe de croissance) doivent être mis en place l'un par rapport à l'autre lorsque le système est encore à température ambiante. Pour permettre cette mise en place, un espacement suffisant doit exister entre les deux parties de même forme comme illustré à la figure 1.

Lors de l'étape suivante, le creuset 100 est placé dans une enceinte 4 sous vide ou sous atmosphère contrôlée et est chauffé via un système de chauffage 5 pour le mettre à température de fonctionnement. La température de fonctionnement dans le creuset est comprise entre 2000°C et 2100°C, et est de préférence d'au moins 2050°C au sommet du fond 2, température à partir de laquelle le saphir entre en fusion.

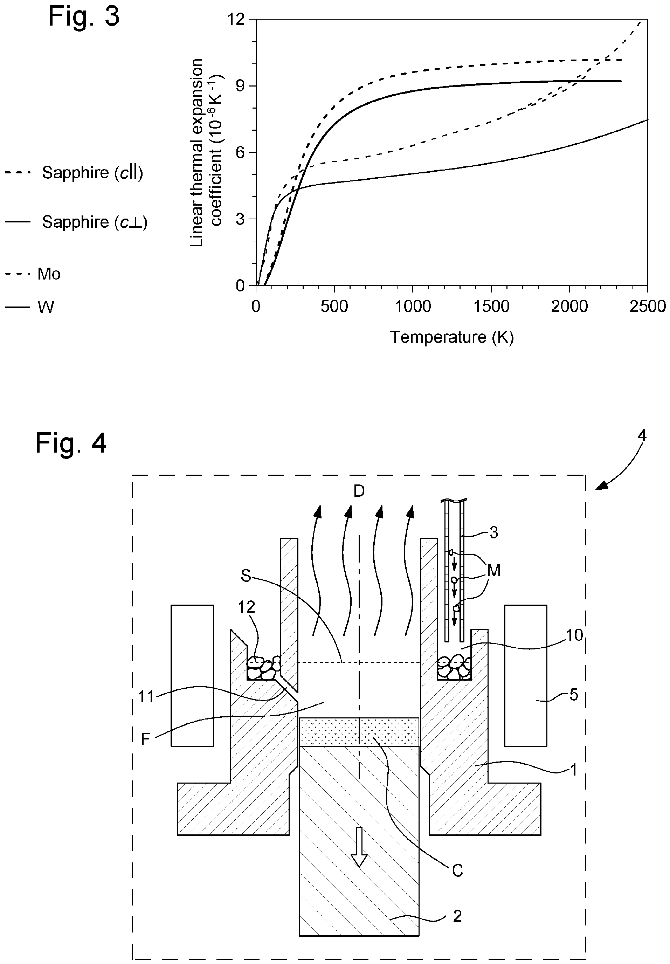

Lorsque le creuset 100 est à température de fonctionnement, une température très légèrement supérieure à la température de 2050°C de fusion du saphir doit être atteinte à la surface du germe. La première partie 1 en métal et la deuxième partie en saphir se seront donc toutes les deux dilatées avec la hausse de la température. La première partie en métal se sera cependant moins dilatée que le fond 2 en saphir, comme le montre les courbes de coefficients de dilatation de ces deux matières de la figure 3. Ainsi, il est possible de calculer les dimensions respectives des deux parties afin d'atteindre un jeu quasi-nul entre les deux parties à température de fonctionnement. Un tel agencement permet, d'une part, l'étanchéité du montage aux écoulements de saphir en fusion, et d'autre part, un entrainement possible du fond 2 (ou germe de saphir) vers le bas, celui-ci coulissant dans l'ouverture interne 13 de la première partie métallique du creuset restant fixe.

La suite du procédé consiste à venir alimenter le creuset 100 ainsi constitué avec de la matière première « M » pour la transformer en matière première en fusion « F », en quantité relativement faible à chaque instant. La zone de saphir liquide (ou en fusion) au-dessus du germe est ainsi d'épaisseur relativement faible, et comporte une surface d'échange « S » avec l'atmosphère de l'enceinte, dans laquelle se trouve placé le système, égale à la section du cylindre et comparativement relativement grande.

Il est ainsi possible de favoriser le plus possible le dégazage « D » du saphir liquide. Afin d'être compatible avec l'utilisation des métaux molybdène ou tungstène ou un alliage de ces deux métaux à haute température, l'enceinte dans laquelle se déroule le procédé est une enceinte étanche à l'air dans laquelle aura été réalisé au préalable un vide poussé ou une vidange complète de l'air par un gaz neutre.

Pour conserver une zone de matière première de saphir en fusion F en quantité constante relativement faible à chaque instant, un système d'alimentation 3 est préférentiellement utilisé, et celui-ci peut être continu ou non continu.

Un système d'alimentation en continu 3 permet d'apporter de la matière première M sous forme finement divisée, et permet ainsi une régulation précise de la quantité apportée à chaque instant, celle-ci devant correspondre précisément à la quantité cristallisée dans le même temps.

La fusion de la matière première M se produit préférentiellement dans une zone distincte de la zone se trouvant directement au-dessus du germe, afin de ne pas perturber la cristallisation. Avantageusement, une gorge de réception 10 formant une zone de fusion est prévue sur la face externe autour de la première partie métallique 1 du creuset et communique avec l'ouverture interne 13 par le biais de canaux d'alimentation 11, comme visible sur les figures 1, 2 et 4. Cette zone de fusion est avantageusement garnie de chips, d'éclats, granulés, pellets ou pastilles 12 métalliques, comme du molybdène ou du tungstène, sur lesquels se produira la fusion de la matière première M.

La matière première en fusion F s'écoule ensuite dans l'ouverture interne 13 du creuset via les canaux 11. Un tel agencement permet de bénéficier d'un effet de dégazage supplémentaire.

La suite du procédé pourra se dérouler toujours sous vide avec un pompage P en continu, ou sous une atmosphère d'argon ou d'un autre gaz neutre, mais de préférence sous une pression réduite et avec un pompage P en continu pour favoriser le dégazage du saphir en fusion.

En outre, un environnement de chauffage et d'isolation sans carbone (C) est de préférence utilisé afin d'éviter la formation de gaz de monoxyde de carbone (CO) pouvant se dissoudre dans le saphir en fusion, des éléments de chauffage métalliques seront donc préférés.

L'étape suivante consiste à effectuer un déplacement en translation du fond 2 du creuset, à vitesse contrôlée, pour solidifier progressivement la matière première en fusion F et former progressivement un monocristal de saphir C sous la forme d'une barre. Ce déplacement s'effectue vers la zone basse moins chauffée dans l'enceinte 4, et donc plus froide, pour solidifier la matière première en fusion.

La cristallisation du saphir s'obtient par un déplacement en translation, à vitesse contrôlée par un système de translation motorisé 6, du fond 2 du creuset (i.e. du germe de saphir) vers le bas, la première partie métallique 1 du creuset étant supportée par une structure solidaire de l'enceinte 4 et restant ainsi fixe au cours de la fabrication du monocristal de saphir.

La matière première en fusion F (ou saphir liquide) se situant à l'interface avec le fond 2 est alors déplacée dans une zone plus froide et se solidifie en conservant l'orientation et le profil du fond 2 du creuset (i.e. du germe). Les éventuelles bulles et gaz dissous, pour autant qu'ils subsistent et que le déplacement ne se produise pas trop rapidement, ne sont ainsi pas incorporés dans le saphir cristallisé.

La position de l'interface liquide/solide reste sensiblement constante tout au long du procédé. La longueur de la barre de saphir pouvant être cristallisée dépend de la course totale du système de translation, la capacité du réservoir de matière première devant être au moins égale à celle du poids de barre pouvant être cristallisée.

Le procédé s'achève par interruption de l'alimentation en matière première M et cristallisation complète de la zone de saphir en fusion, suivi du refroidissement du creuset 100 jusqu'à température ambiante.

Une fois le tout refroidit, il reste à récupérer la barre de saphir C soudée au germe 2, le germe 2 et/ou une portion de la barre C pouvant être sciée pour former à la fois un nouveau fond 2 et donc un nouveau germe de départ.

Ainsi, le procédé est répétable par la mise en place d'un nouveau fond ou germe dans la même première partie métallique du creuset. Ce nouveau germe pourra être simplement le germe utilisé initialement et/ou une petite portion de la barre obtenue, récupérée par sciage. Le germe est donc indéfiniment régénéré, sans opérations compliquées de ré-usinage pour obtenir un fond (ou germe) aux bonnes dimensions.

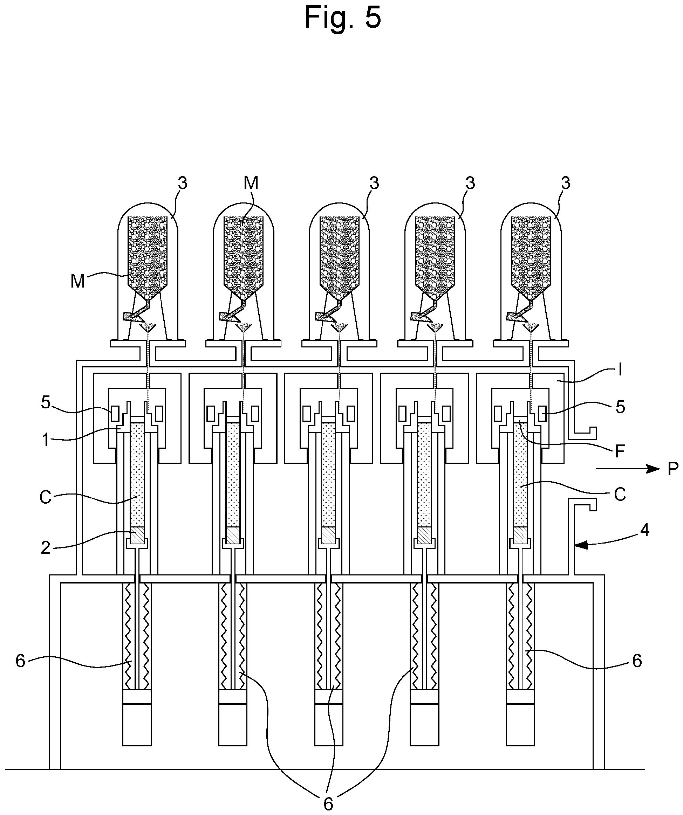

La figure 5 illustre un exemple de dispositif pour la fabrication d'un monocristal de saphir directement sous la forme d'une barre. Une même enceinte sous vide ou sous atmosphère contrôlée peut comprendre plusieurs creusets et germes de départ, et autant de systèmes de chauffage, d'isolation, de systèmes d'alimentation continu en matière première et de systèmes de translation, fonctionnant en parallèle, pour permettre une augmentation de la production de barres de saphir par ce procédé à moindre coût.

La présente invention permet également la fabrication de glaces de montre, de fonds à partir d'une barre de saphir obtenue selon le procédé décrit précédemment. Il va de soi que cet exemple est donné à titre purement illustratif et non limitatif seulement et que la fabrication de composants d'habillage et fonctionnels notamment pour l'horlogerie et la bijouterie tels que des ponts, des platines, des boîtes et des cadrans de montre ou bien encore des maillons de bracelet est également possible.

## Revendications

1. Procédé de fabrication d'un saphir monocristallin directement sous forme de barre, le procédé comprenant les étapes suivantes :
- mise à disposition d'un creuset (100), le creuset comprenant une première partie fixe (1) avec une ouverture interne (13), et une deuxième partie (2) mobile formant le fond du creuset et qui est constituée d'une pièce en saphir formant un germe de départ pour la croissance du saphir ;
- mettre en place la première partie (1) et la deuxième partie (2) l'une par rapport à l'autre à la température ambiante, la deuxième partie étant mobile en translation dans l'ouverture interne (13) de la première partie ;
- placer le creuset (100) dans une enceinte (4) sous vide ou sous atmosphère contrôlée et chauffer dans l'enceinte (4) pour mettre à température de fonctionnement le creuset ;
- alimenter le creuset avec de la matière première (M) via un système d'alimentation (3) pour former de la matière première en fusion (F) dans le creuset, au-dessus de la partie mobile en saphir ;
- effectuer un déplacement en translation du fond (2) du creuset via des moyens de déplacement, à vitesse contrôlée, pour solidifier progressivement la matière première en fusion et former progressivement une barre de saphir (C) ayant la même section que celle du fond (2) du creuset (100) ;
- interrompre l'alimentation de matière première (M) et cristalliser complètement la matière en fusion (F) restante dans le creuset ;
- refroidir le creuset jusqu'à température ambiante ;
- récupérer la barre de saphir obtenue soudée au germe ;
- optionnellement scier le germe et/ou une portion de la barre pour former à la fois un nouveau fond et un nouveau germe de départ.

2. Procédé de fabrication d'un saphir monocristallin selon la revendication 1, dans lequel l'ouverture interne (13) de la première partie est cylindrique et présente une section correspondant sensiblement à la section de la barre de saphir souhaitée.

3. Procédé de fabrication d'un saphir monocristallin selon la revendication 1 ou 2, dans lequel le fond (2) en saphir est de forme cylindrique et présente une section correspondant à la section souhaitée de la barre de saphir.

4. Procédé de fabrication d'un saphir monocristallin selon l'une des revendications 1 à 3, dans lequel la première partie (1) du creuset est réalisée en un métal réfractaire tel que du molybdène, du tungstène ou un alliage de ces deux métaux.

5. Procédé de fabrication d'un saphir monocristallin selon l'une des revendications 1 à 4, dans lequel la température de fonctionnement dans le creuset (100) est comprise entre 2000°C et 2100°C.

6. Procédé de fabrication d'un saphir monocristallin selon l'une des revendications 1 à 5, dans lequel les première partie (1) et deuxième partie (2) sont dimensionnées pour atteindre un jeu minimal lorsqu'elles sont à température de fonctionnement.

7. Procédé de fabrication d'un saphir monocristallin selon l'une des revendications 1 à 6, dans lequel la matière première (M) est de composition chimique Al₂O₃ pure ou dopée.

8. Procédé de fabrication d'un saphir monocristallin selon la revendication 7, dans lequel la matière première (M) est choisie parmi du saphir craquelé broyé, des billes de saphir ou d'alumine, ou de la poudre d'alumine densifiée et compactée sous forme de pellets.

9. Procédé de fabrication d'un saphir monocristallin selon l'une des revendications 1 à 8, dans lequel l'atmosphère contrôlée est composée d'un gaz neutre.

10. Procédé de fabrication d'un saphir monocristallin selon la revendication 9, dans lequel le gaz neutre est de l'argon.

11. Procédé de fabrication selon l'une des revendications 1 à 9, **caractérisé en ce que** les moyens de déplacement en translation sont gérés par un système de translation motorisé (6).

12. Procédé de fabrication selon l'une des revendications 1 à 11, dans lequel la capacité du système d'alimentation (3) de matière première (M) est au moins égale à celle du poids de la barre de saphir pouvant être cristallisée.

13. Procédé de fabrication selon l'une des revendications 1 à 12, dans lequel l'orientation cristallographique du fond ou germe de saphir peut être choisie indistinctement parmi toutes les orientations cristallographiques du saphir.

14. Procédé de fabrication selon l'une des revendications 1 à 13, **caractérisé en ce que**, une fois la barre de saphir obtenue, on découpe des composants d'habillage ou fonctionnels pour l'horlogerie et la bijouterie dans cette barre de saphir.

15. Procédé de fabrication selon la revendication 14, **caractérisé en ce que** la découpe des composants d'habillage ou fonctionnels pour l'horlogerie et la bijouterie dans cette barre de saphir est effectuée par sciage au fil

16. Procédé de fabrication selon l'une des revendications 1 à 14, dans lequel une même enceinte sous vide ou atmosphère contrôlée est utilisée pour plusieurs creusets, systèmes de chauffage, d'alimentation en matière première et moyens de déplacement en translation.

17. Composants d'habillage et fonctionnels pour l'horlogerie et la bijouterie découpés dans un monocristal de saphir obtenu par mise en oeuvre du procédé de fabrication selon l'une des revendications 1 à 16.

18. Composants d'habillage et fonctionnels selon la revendication 17, **caractérisé en ce qu'**il s'agit de ponts, de platines, de glaces, de boîtes et de cadrans de montre ou bien encore de maillons de bracelet.
